# EUROPEAN PATENT APPLICATION

(11) **EP 4 852 058 A1**
(43) Date of publication of application: **09.12.2026**
(21) Application number: 24922471.8
(22) Date of filing: 13.11.2024
(51) Int. Cl.: H01L 25/075, H10H 20/857, H10H 20/831, H10H 20/832, H10H 20/833, H10H 20/854, G09G 3/32

(54) **DISPLAY DEVICE AND DISPLAY SYSTEM COMPRISING SAME**

(30) Priority: 01.02.2024 KR 20240016022
(71) Applicant: Samsung Display Co., Ltd., Yongin-si, Gyeonggi-do 17113 (KR)
(72) Inventor: PARK, Do Yeong, Yongin-si, Gyeonggi-do 17113 (KR); KIM, Yeon Kyung, Yongin-si, Gyeonggi-do 17113 (KR); HONG, Sung Chul, Yongin-si, Gyeonggi-do 17113 (KR)
(74) Representative: Marks & Clerk LLP
(86) International application number: PCT/KR2024/096517
(87) International publication number: WO 2025/164963

(57) **Abstract**

A display device includes a display element layer disposed on a substrate, and the display element layer includes an anode electrode and a cathode electrode, a first reflective electrode disposed on the anode electrode, a second reflective electrode disposed on the cathode electrode, a light emitting element including a first bonding electrode and a second bonding electrode, a first organic layer disposed on the light emitting element and disposed between the anode electrode and the cathode electrode in a plan view, a first transparent electrode directly electrically connecting the first reflective electrode and the first bonding electrode, and a second transparent electrode directly electrically connecting the second reflective electrode and the second bonding electrode.

## Description

### Technical Field

The disclosure relates to a display device and a display system including the same.

### Background Art

As information technology develops, importance of a display device, which is a connection medium between a user and information, is emerging. In response to this, use of a display device such as a liquid crystal display device, an organic light emitting display device, and an inorganic light emitting display device is increasing.

Some display devices are gradually miniaturized. Accordingly, a size of a pixel (or a sub-pixel) and a distance between pixels (or sub-pixels) in a display device (or a display panel) are gradually decreasing. Accordingly, a method of preventing a short circuit due to a residue that may occur during a process of the display device may be required.

### Detailed Description of Invention

### Technical Problem

An object of the disclosure is to provide a display device and a display system including the same that prevent a short circuit due to a residue.

### Technical Solution

The technical objectives to be achieved by the disclosure are not limited to those described herein, and other technical objectives that are not mentioned herein would be clearly understood by a person skilled in the art from the description of the disclosure.

According to embodiments of the disclosure, a display device includes a display element layer disposed on a substrate, and the display element layer includes an anode electrode and a cathode electrode, a first reflective electrode disposed on the anode electrode, a second reflective electrode disposed on the cathode electrode, a light emitting element including a first bonding electrode and a second bonding electrode, a first organic layer disposed on the light emitting element and disposed between the anode electrode and the cathode electrode in a plan view, a first transparent electrode directly electrically connecting the first reflective electrode and the first bonding electrode, and a second transparent electrode directly electrically connecting the second reflective electrode and the second bonding electrode.

In embodiments, the display device may further include sub-pixels arranged in a first direction, the anode electrode may include anode electrodes corresponding to the respective sub-pixels, and the first organic layer may extend in the first direction.

In embodiments, the display device may further include a second organic layer disposed on the light emitting element and disposed between the anode electrodes in a plan view.

In embodiments, the second organic layer may extend in a second direction perpendicular to the first direction, and the first organic layer may be disposed at an end of the second organic layer in a plan view.

In embodiments, the second organic layer may extend in the first direction and overlap a portion of each of the anode electrodes.

In embodiments, the first transparent electrode may be disposed on the second organic layer.

In embodiments, the display device may further include a third organic layer disposed at the other end of the second organic layer in a plan view, and the third organic layer may extend in the first direction.

In embodiments, the display device may further include a fourth organic layer disposed on the light emitting element and extending in the second direction in a plan view; and a fifth organic layer extending in the first direction in a plan view, wherein the first organic layer is disposed at one an end of the fourth organic layer, and the fifth organic layer is disposed at the other end of the fourth organic layer.

In embodiments, the fourth organic layer may overlap a portion of the cathode electrode in a plan view.

In embodiments, the second transparent electrode may be disposed on the fourth organic layer.

In embodiments, the fifth organic layer may overlap a portion of the cathode electrode in a plan view.

In embodiments, the display element layer may further include an overcoat layer disposed in an opening where the first reflective electrode, the second reflective electrode, and the light emitting element are disposed.

In embodiments, the overcoat layer may be directly adjacent to the light emitting element.

In embodiments, the display element layer may be disposed on an upper direction of the substrate, and the first bonding electrode and the second bonding electrode face a lower direction of the substrate.

In embodiments, the anode electrode and the cathode electrode may be disposed in a same layer and include a same conductive material.

In embodiments, the first transparent electrode and the second transparent electrode may be patterned after patterning the first organic layer.

In embodiments, the first reflective electrode and the second reflective electrode may be disposed in a same layer and include a same reflective conductive material.

In embodiments, the first transparent electrode and the second transparent electrode may be disposed in a same layer and include a same transparent conductive material.

In embodiments, the first bonding electrode and the second bonding electrode may be disposed on a side surface and a lower surface of the light emitting element, and the first bonding electrode and the second bonding electrode may be spaced apart from each other.

According to embodiments of the disclosure, a display system includes a processor providing image data and a control signal, and a display device including a display panel configured to display an image corresponding to the image data in response to the control signal, and the display panel includes an anode electrode and a cathode electrode, a first reflective electrode disposed on the anode electrode, a second reflective electrode disposed on the cathode electrode, a light emitting element including a first bonding electrode and a second bonding electrode, a first organic layer disposed on the light emitting element and disposed between the anode electrode and the cathode electrode in a plan view, a first transparent electrode directly electrically connecting the first reflective electrode and the first bonding electrode, and a second transparent electrode directly electrically connecting the second reflective electrode and the second bonding electrode.

### Advantageous Effects

According to an embodiment of the disclosure, a display device and a display system including the same that prevent a short circuit due to a residue may be provided.

### Description of Drawings

The above and other features of the disclosure will become more apparent by describing in further detail embodiments thereof with reference to the accompanying drawings, in which:
FIG. 1 is a block diagram illustrating an embodiment of a display device.
FIG. 2 is a block diagram illustrating an embodiment of one of sub-pixels of FIG. 1.
FIG. 3 is a plan view illustrating an embodiment of a display panel of FIG. 1.
FIG. 4 is a cross-sectional view illustrating an embodiment of the display panel of FIG. 3.
FIG. 5 is a cross-sectional view illustrating another embodiment of the display panel of FIG. 3.
FIG. 6 is a plan view illustrating an embodiment of one of the pixels of FIG. 3.
FIG. 7 is a cross-sectional view taken along line I-I' of FIG. 6.
FIG. 8A is a plan view illustrating an embodiment of the disclosure including an organic layer.
FIG. 8B is a cross-sectional view taken along line II-II' of FIG. 8A.
FIG. 9 is a plan view illustrating another embodiment of the disclosure including an organic layer.
FIG. 10 is a plan view illustrating another embodiment of the disclosure including an organic layer.
FIG. 11A is a plan view illustrating an embodiment of the disclosure including an organic layer.
FIG. 11B is a cross-sectional view taken along line III-III' of FIG. 11A.
FIG. 11C is a cross-sectional view taken along line IV-IV' of FIG. 11A.
FIG. 12 is a plan view illustrating another embodiment of the disclosure including an organic layer.
FIG. 13 is a block diagram illustrating an embodiment of a display system.
FIGS. 14 to 17 are perspective views illustrating application examples of the display system of FIG. 13.

### Modes of the Invention

Hereinafter, an embodiment according to the disclosure is described in detail with reference to the accompanying drawings. It should be noted that in the following description, only portions necessary for understanding an operation according to the disclosure are described, and descriptions of other portions are omitted in order not to obscure the subject matter of the disclosure. In addition, the disclosure may be embodied in other forms without being limited to the embodiment described herein. However, the embodiment described herein is provided to describe in detail enough to easily implement the technical concept of the disclosure to those skilled in the art to which the disclosure belongs.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. "At least any one of X, Y, and Z" and "at least any one selected from a group consisting of X, Y, and Z" may be interpreted as one X, one Y, one Z, or any combination of two or more of X, Y, and Z (for example, XYZ, XYY, YZ, and ZZ). Here, "and/or" includes all combinations of one or more of corresponding configurations.

Here, terms such as first and second may be used to describe various components, but these components are not limited to these terms. These terms are used to distinguish one component from another component. Therefore, a first component may refer to a second component within a range without departing from the scope disclosed herein.

Spatially relative terms such as "under", "on", and the like may be used for descriptive purposes, thereby describing a relationship between one element or feature and another element(s) or feature(s) as shown in the drawings. Spatially relative terms are intended to include other directions in use, in operation, and/or in manufacturing, in addition to the direction depicted in the drawings. For example, when a device shown in the drawing is turned upside down, elements depicted as being positioned "under" other elements or features are positioned in a direction "on" the other elements or features. Therefore, in an embodiment, the term "under" may include both directions of on and under. In addition, the device may face in other directions (for example, rotated 90 degrees or in other directions) and thus the spatially relative terms used herein are interpreted according thereto.

Various embodiments are described with reference to drawings schematically illustrating ideal embodiments. Accordingly, it will be expected that shapes may vary, for example, according to tolerances and/or manufacturing techniques. Therefore, the embodiments disclosed herein cannot be construed as being limited to shown specific shapes, and should be interpreted as including, for example, changes in shapes that occur as a result of manufacturing. As described above, the shapes shown in the drawings may not show actual shapes of areas of a device, and the embodiments are not limited thereto.

As customary in the field, some embodiments are described and illustrated in the accompanying drawings in terms of functional blocks, units, parts, and/or modules. Those skilled in the art will appreciate that these blocks, units, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, parts, and/or modules being implemented by microprocessors or other similar hardware, they may be programmed and controlled using software (e.g., microcode) to perform various functions discussed herein and may optionally be driven by firmware and/or software. It is also contemplated that each block, unit, part, and/or module may be implemented by dedicated hardware, or as a combination of dedicated hardware to perform some functions and a processor (e.g., one or more programmed microprocessors and associated circuitry) to perform other functions. Also, each block, unit, part, and/or module of some embodiments may be physically separated into two or more interacting and discrete blocks, units, parts, and/or modules without departing from the scope of the disclosure. Further, the blocks, units, parts, and/or modules of some embodiments may be physically combined into more complex blocks, units, parts, and/or modules without departing from the scope of the disclosure.

The term "and/or" includes all combinations of one or more of which associated configurations may define. For example, "A and/or B" may be understood to mean "A, B, or A and B."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

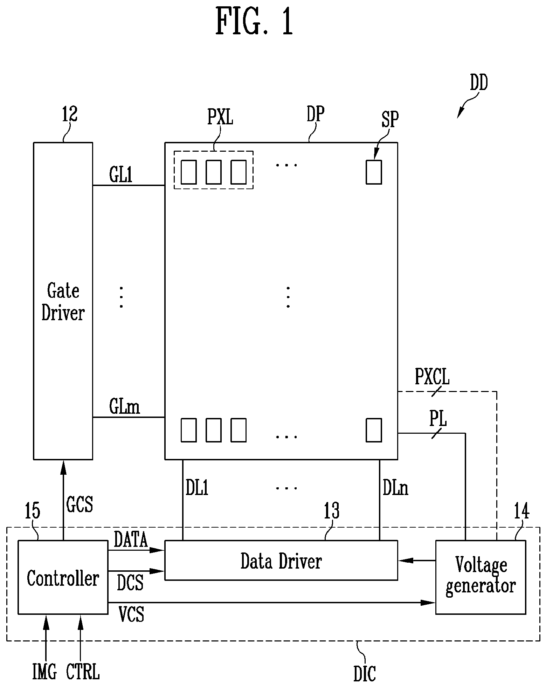

FIG. 1 is a block diagram illustrating an embodiment of a display device.

Referring to FIG. 1, the display device DD may include a display panel DP, a gate driver 12, a data driver 13, a voltage generator 14, and a controller 15.

The display panel DP may include sub-pixels SP. The sub-pixels SP may be connected to the gate driver 12 through first to m-th gate lines GL1 to GLm. The sub-pixels SP may be connected to the data driver 13 through first to n-th data lines DL1 to DLn.

The sub-pixels SP may generate of light of two or more colors. For example, each of the sub-pixels SP may generate light of a color such as red, green, blue, cyan, magenta, or yellow.

Two or more sub-pixels among the sub-pixels SP may configure a pixel PXL. For example, the pixel PXL may include three sub-pixels as shown in FIG. 1. As described above, the pixel PXL may emit light of various colors and various luminances according to a combination of light emitted from the sub-pixels SP included in the pixel PXL.

The gate driver 12 may be connected to the sub-pixels SP arranged in a row direction through the first to m-th gate lines GL1 to GLm. The gate driver 12 may output gate signals to the first to m-th gate lines GL1 to GLm in response to a gate control signal GCS. In embodiments, the gate control signal GCS may include a start signal indicating a start of each frame, a horizontal synchronization signal, and the like.

The gate driver 12 may be disposed on a side of the display panel DP. However, embodiments are not limited thereto. For example, the gate driver 12 may be divided into two or more physically and/or logically divided drivers, and such drivers may be disposed on a side of the display panel DP and another side of the display panel DP opposite the side. As described above, the gate driver 12 may be disposed around the display panel DP in various shapes according to embodiments.

The data driver 13 may be connected to the sub-pixels SP arranged in a column direction through the first to n-th data lines DL1 to DLn. The data driver 13 may receive image data DATA and a data control signal DCS from the controller 15. The data driver 13 may operate in response to the data control signal DCS. In embodiments, the data control signal DCS may include a source start signal, a source shift clock, a source output enable signal, and the like.

The data driver 13 may receive voltages from the voltage generator 14. The data driver 13 may apply data signals having grayscale voltages corresponding to the image data DATA to the first to n-th data lines DL1 to DLn by using the received voltages. In a case that the gate signal is applied to each of the first to m-th gate lines GL1 to GLm, the data signals corresponding to the image data DATA may be applied to the data lines DL1 to DLn. Accordingly, the sub-pixels SP may generate light corresponding to the data signals, and the display panel DP may display an image.

In embodiments, the gate driver 12 and the data driver 13 may include complementary metal-oxide semiconductor (CMOS) circuit elements.

The voltage generator 14 may operate in response to a voltage control signal VCS from the controller 15. The voltage generator 14 may be configured to generate voltages and provide the generated voltages to components of the display device DD, such as the gate driver 12, the data driver 13, and the controller 15. The voltage generator 14 may generate the voltages by receiving an input voltage from an outside of the display device DD and regulating the received voltage.

The voltage generator 14 may generate a first power voltage and a second power voltage. The generated first and second power voltages may be provided to the sub-pixels SP through power lines PL. In another embodiment, at least one of the first and second power voltages may be provided from the outside of the display device DD.

The voltage generator 14 may provide various voltages and/or signals. For example, the voltage generator 14 may provide one or more initialization voltages applied to the sub-pixels SP. For example, during a sensing operation for sensing electrical characteristics of transistors and/or light emitting elements of the sub-pixels SP, a reference voltage (e.g., a predetermined or selectable reference voltage) may be applied to the first to n-th data lines DL1 to DLn, and the voltage generator 14 may generate the reference voltage and transmit the reference voltage to the data driver 13. For example, during a display operation for displaying an image on the display panel DP, common pixel control signals may be applied to the sub-pixels SP, and the voltage generator 14 may generate the pixel control signals. In embodiments, the voltage generator 14 may provide the pixel control signals to the sub-pixels SP through pixel control lines PXCL. In FIG. 1, the pixel control lines PXCL may be connected between the voltage generator 14 and the display panel DP, but embodiments are not limited thereto. For example, the pixel control lines PXCL may be connected between the gate driver 12 and the display panel DP. In this case, the pixel control signals may be transmitted from the voltage generator 14 to the pixel control lines PXCL through the gate driver 12.

The controller 15 may control overall operations of the display device DD. The controller 15 may receive input image data IMG and a control signal CTRL corresponding thereto from the outside. The controller 15 may provide the gate control signal GCS, the data control signal DCS, and the voltage control signal VCS in response to the control signal CTRL.

The controller 15 may convert the input image data IMG so that the input image data IMG is suitable for the display device DD or the display panel DP, and may output the image data DATA. In embodiments, the controller 15 may output the image data DATA by aligning the input image data IMG so that the input image data IMG is suitable for the sub-pixels SP of a row unit.

Two or more components of the data driver 13, the voltage generator 14, and the controller 15 may be mounted on one integrated circuit. As shown in FIG. 1, the data driver 13, the voltage generator 14, and the controller 15 may be included in a driver integrated circuit DIC. In this case, the data driver 13, the voltage generator 14, and the controller 15 may be functionally divided components in one driver integrated circuit DIC. In other embodiments, at least one of the data driver 13, the voltage generator 14, and the controller 15 may be provided as a component distinguished from the driver integrated circuit DIC.

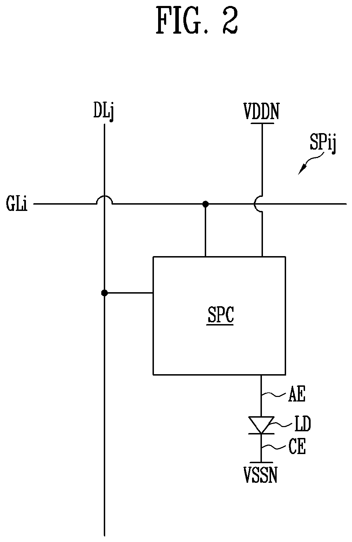

FIG. 2 is a schematic block diagram illustrating an embodiment of one of the sub-pixels of FIG. 1. In FIG. 2, among the sub-pixels SP of FIG. 1, a sub-pixel SPij arranged in an i-th row (where i is an integer greater than or equal to 1 and less than or equal to m) and a j-th column (where j is an integer greater than or equal to 1 and less than or equal to n) is shown as an example.

Referring to FIG. 2, the sub-pixel SPij may include a sub-pixel circuit SPC and a light emitting element LD.

The light emitting element LD may be connected between a first power voltage node VDDN and a second power voltage node VSSN. The first power voltage node VDDN may be connected to one of the power lines PL of FIG. 1 and may receive the first power voltage. The second power voltage node VSSN may be connected to another one of the power lines PL of FIG. 1 and may receive the second power voltage. The first power voltage may have a voltage level greater than that of the second power voltage.

The light emitting element LD may be connected between an anode electrode AE and a cathode electrode CE. The anode electrode AE may be connected to the first power voltage node VDDN through the sub-pixel circuit SPC. For example, the anode electrode AE may be connected to the first power voltage node VDDN through one or more transistors included in the sub-pixel circuit SPC. The cathode electrode CE may be connected to the second power voltage node VSSN. The light emitting element LD may be configured to emit light according to a current flowing from the anode electrode AE to the cathode electrode CE.

The sub-pixel circuit SPC may be connected to an i-th gate line GLi among the first to m-th gate lines GL1 to GLm of FIG. 1, and to a j-th data line DLj among the first to n-th data lines DL1 to DLn of FIG. 1. In response to a gate signal received through the i-th gate line GLi, the sub-pixel circuit SPC may control the light emitting element LD to emit light according to a data signal received through the j-th data line DLj. In embodiments, the sub-pixel circuit SPC may be further connected to the pixel control lines PXCL of FIG. 1. In this case, the sub-pixel circuit SPC may control the light emitting element LD in further response to the pixel control signals received through the pixel control lines PXCL.

For such operations, the sub-pixel circuit SPC may include circuit elements, for example, transistors and one or more capacitors.

The transistors of the sub-pixel circuit SPC may include P-type transistors and/or N-type transistors. In embodiments, the transistors of the sub-pixel circuit SPC may include a metal-oxide-semiconductor field-effect transistor (MOSFET). In embodiments, the transistors of the sub-pixel circuit SPC may include an amorphous silicon semiconductor, a monocrystalline silicon semiconductor, a polycrystalline silicon semiconductor, an oxide semiconductor, and the like.

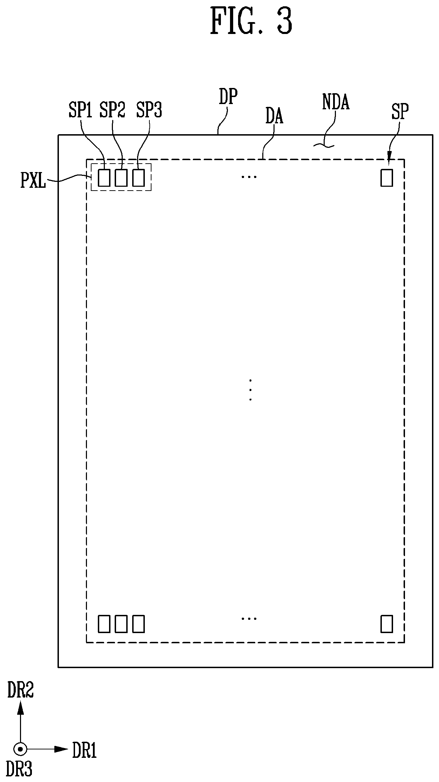

FIG. 3 is a plan view illustrating an embodiment of the display panel of FIG. 1.

Referring to FIG. 3, the display panel DP may include a display area DA and a non-display area NDA. The display panel DP may display an image through the display area DA. The non-display area NDA may be disposed around the display area DA.

The display panel DP may include the sub-pixels SP in the display area DA. The sub-pixels SP may be arranged in a first direction DR1 and a second direction DR2 intersecting the first direction DR1. For example, the sub-pixels SP may be arranged in a matrix form in the first direction DR1 and the second direction DR2. As another example, the sub-pixels SP may be arranged in a zigzag form in the first direction DR1 and the second direction DR2. An arrangement of the sub-pixels SP may vary according to embodiments. The first direction DR1 may be a row direction, and the second direction DR2 may be a column direction.

Two or more sub-pixels among the sub-pixels SP may configure a pixel PXL. In FIG. 3, the pixel PXL may include three sub-pixels SP1 to SP3, but embodiments are not limited thereto. For example, the pixel PXL may include two sub-pixels. Hereinafter, for convenience of description, it is assumed that the pixel PXL includes the first to third sub-pixels SP1 to SP3.

Each of the first to third sub-pixels SP1 to SP3 may generate light of one of various colors such as red, green, blue, cyan, magenta, and yellow. Hereinafter, for clear and concise description, it is assumed that the first sub-pixel SP1 is configured to generate light of a red color, the second sub-pixel SP2 is configured to generate light of a green color, and the third sub-pixel SP3 is configured to generate light of a blue color.

Each of the first to third sub-pixels SP1 to SP3 may include at least one light emitting element configured to generate light. In embodiments, the light emitting elements of the first to third sub-pixels SP1 to SP3 may generate light of a same color. For example, the light emitting elements of the first to third sub-pixels SP1 to SP3 may generate the light of the blue color. In other embodiments, the light emitting elements of the first to third sub-pixels SP1 to SP3 may generate light of different colors. For example, the light emitting elements of the first to third sub-pixels SP1 to SP3 may generate light of a red color, a green color, and a blue color, respectively.

As the display panel DP, a light emitting diode display panel (LED display panel) using a micro scale or nano scale of light emitting diode as a light emitting element, and a display panel capable of self-emission such as an organic light emitting display panel (OLED panel) using an organic light emitting diode as a light emitting element may be used.

A component for controlling the sub-pixels SP may be disposed in the non-display area NDA. Lines connected to the sub-pixels SP, for example, the first to m-th gate lines GL1 to GLm of FIG. 1, the first to n-th data lines DL1 to DLn, the power lines PL, and the pixel control lines PXCL may be disposed in the non-display area NDA.

At least one of the gate driver 12, the data driver 13, the voltage generator 14, and the controller 15 of FIG. 1 may be disposed in the non-display area NDA of the display panel DP. In embodiments, the gate driver 12 may be disposed in the non-display area NDA. In this case, the data driver 13, the voltage generator 14, and the controller 15 may be implemented as the driver integrated circuit DIC of FIG. 1, separate from the display panel DP, and the driver integrated circuit DIC may be connected to the lines disposed in the non-display area NDA. In other embodiments, the gate driver 12 may be implemented as one integrated circuit separate from the display panel DP, together with the data driver 13, the voltage generator 14, and the controller 15.

In embodiments, the display area DA may have various shapes. The display area DA may have a closed-loop shape including sides of a straight line and/or a curved line. For example, the display area DA may have shapes of a polygon, a circle, a semicircle, an ellipse, and the like.

In embodiments, the display panel DP may have a flat display surface. In other embodiments, the display panel DP may have a display surface that is at least partially round. In embodiments, the display panel DP may be bendable, foldable, or rollable. In such cases, the display panel DP and/or a substrate of the display panel DP may include materials having a flexible property.

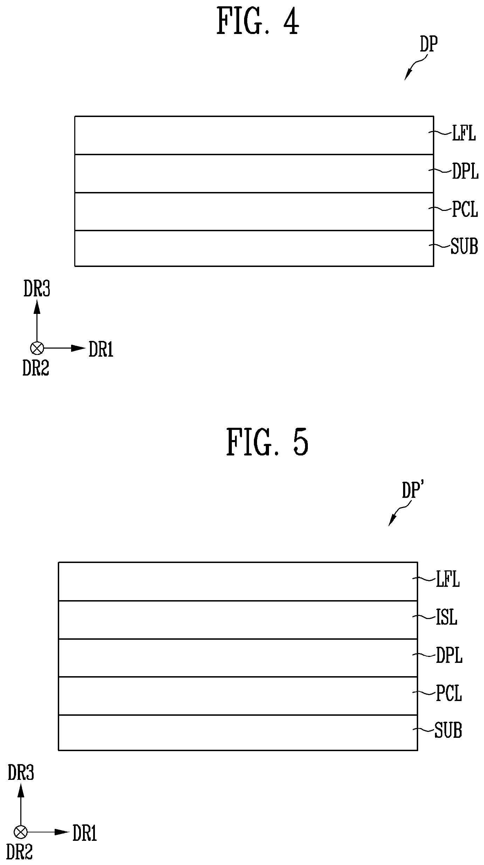

FIG. 4 is a cross-sectional view illustrating an embodiment of the display panel of FIG. 3.

Referring to FIG. 4, the display panel DP may include a substrate SUB, a pixel circuit layer PCL, a display element layer DPL, and a light functional layer LFL sequentially stacked on the substrate SUB in a third direction DR3 intersecting the first and second directions DR1 and DR2.

The substrate SUB may be formed of an insulating material such as glass or resin. For example, the substrate SUB may include a glass substrate. As another example, the substrate SUB may include a polyimide (PI) substrate. As still another example, the substrate SUB may include a silicon wafer substrate formed using a semiconductor process.

In embodiments, the substrate SUB may be formed of a flexible material that may be bent or folded, and may have a single-layer structure or a multi-layer structure. For example, the flexible material may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate. However, embodiments are not limited thereto.

The pixel circuit layer PCL may be disposed on the substrate SUB. The pixel circuit layer PCL may include insulating layers and semiconductor patterns and conductive patterns disposed between the insulating layers. The conductive patterns of the pixel circuit layer PCL may function as circuit elements, lines, and the like.

The circuit elements of the pixel circuit layer PCL may include the sub-pixel circuit SPC (see FIG. 2) of each of the sub-pixels SP of FIG. 3. In other words, the circuit elements of the pixel circuit layer PCL may be provided as transistors and one or more capacitors of the sub-pixel circuit SPC.

The lines of the pixel circuit layer PCL may include lines connected to the sub-pixels SP. The lines of the pixel circuit layer PCL may include various signal lines and/or voltage lines necessary for driving the display element layer DPL.

The display element layer DPL may be disposed on the pixel circuit layer PCL. The display element layer DPL may include light emitting elements of the sub-pixels SP.

The light functional layer LFL may be disposed on the display element layer DPL. The light functional layer LFL may include light conversion patterns having color conversion particles and/or scattering particles. For example, the color conversion particles may include quantum dots. The quantum dots may change a wavelength (or color) of light emitted from the display element layer DPL. The light functional layer LFL may further include light scattering patterns having the scattering particles. In embodiments, the light conversion patterns and the light scattering patterns may be omitted.

The light functional layer LFL may further include a color filter layer including color filters. The color filter may selectively transmit light of a specific wavelength (or a specific color). In embodiments, the color filter layer may be omitted.

A window for protecting an exposure surface (or an upper surface) of the display panel DP may be provided on the light functional layer LFL. The window may protect the display panel DP from external shock. The window may be coupled to the light functional layer LFL through an optically transparent adhesive (or cohesive) member. The window may have a multi-layer structure selected from a glass substrate, a plastic film, and a plastic substrate. The multi-layer structure may be formed through a continuous process or an adhesion process using an adhesive layer. All or a portion of the window may be flexible.

FIG. 5 is a cross-sectional view illustrating another embodiment of the display panel of FIG. 3.

Referring to FIG. 5, a display panel DP' may include the substrate SUB, the pixel circuit layer PCL, the display element layer DPL, an input sensing layer ISL, and the light functional layer LFL. The substrate SUB, the pixel circuit layer PCL, the display element layer DPL, and the light functional layer LFL may be configured similarly to the substrate SUB, the pixel circuit layer PCL, the display element layer DPL, and the light functional layer LFL described with reference to FIG. 4. Hereinafter, an overlapping description is omitted.

The input sensing layer ISL may sense a user input on an upper surface (or a display surface) of the display panel DP'. The input sensing layer ISL may include components suitable for sensing an external object such as a user's hand or a pen. For example, the input sensing layer ISL may include touch electrodes.

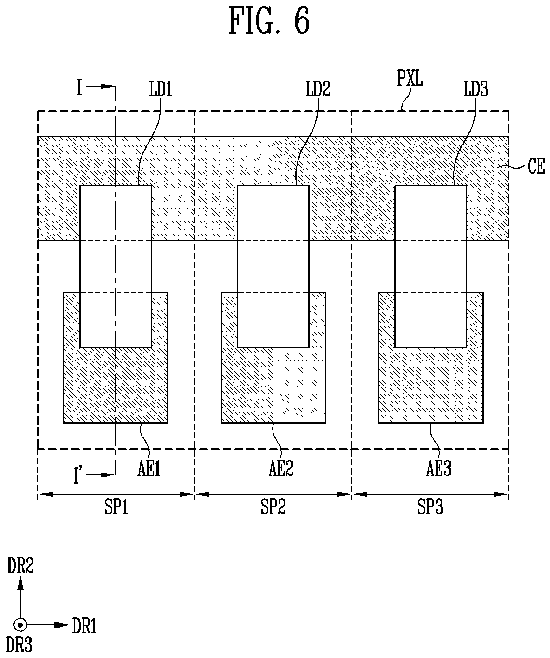

FIG. 6 is a plan view illustrating an embodiment of one of the pixels of FIG. 3.

Referring to FIG. 6, the pixel PXL may include the first to third sub-pixels SP1 to SP3. The first to third sub-pixels SP1 to SP3 may be arranged in the first direction DR1. However, an arrangement of the pixel PXL is not limited thereto and may variously change according to embodiments. For example, the first to third sub-pixels SP1 to SP3 may be arranged in a zigzag.

First to third anode electrodes AE1 to AE3 may be disposed in the first to third sub-pixels SP1 to SP3, respectively. The first anode electrode AE1 may be provided as the anode electrode AE (see FIG. 2) connected to the sub-pixel circuit SPC (see FIG. 2) of the first sub-pixel SP1. The second anode electrode AE2 may be provided as the anode electrode AE connected to the sub-pixel circuit SPC of the second sub-pixel SP2. The third anode electrode AE3 may be provided as the anode electrode AE connected to the sub-pixel circuit SPC of the third sub-pixel SP3.

The cathode electrode CE may be spaced apart from the first to third anode electrodes AE1 to AE3. The cathode electrode CE and the first to third anode electrodes AE1 to AE3 may be disposed at a same height. The cathode electrode CE may be spaced apart from the first to third anode electrodes AE1 to AE3 in the second direction DR2. In embodiments, the cathode electrode CE may extend in the first direction DR1 and may be used as a common electrode for the pixel PXL and other pixels adjacent to the pixel PXL. Although not shown, the cathode electrode CE may extend not only in the first direction DR1 but also in the second direction DR2 and may be used as a common electrode for all the sub-pixels SP of FIG. 3. As described above, the cathode electrode CE may have various shapes. In embodiments, the first to third anode electrodes AE1 to AE3 and the cathode electrode CE may include a same conductive material.

First to third light emitting elements LD1 to LD3 may be disposed on the first to third anode electrodes AE1 to AE3 and the cathode electrode CE. The first light emitting element LD1 may be electrically connected to the first anode electrode AE1 and the cathode electrode CE. The first light emitting element LD1 may be provided as the light emitting element LD (see FIG. 2) connected to the sub-pixel circuit SPC of the first sub-pixel SP1. The second light emitting element LD2 may be electrically connected to the second anode electrode AE2 and the cathode electrode CE. The second light emitting element LD2 may be provided as the light emitting element LD connected to the sub-pixel circuit SPC of the second sub pixel SP2. The third light emitting element LD3 may be electrically connected to the third anode electrode AE3 and the cathode electrode CE. The third light emitting element LD3 may be provided as the light emitting element LD connected to the sub-pixel circuit SPC of the third sub pixel SP3.

The first light emitting element LD1, the second light emitting element LD2, and the third light emitting element LD3 may be inorganic light emitting diodes including an inorganic light emitting material. However, embodiments are not limited thereto, and for example, organic light emitting diodes may be used.

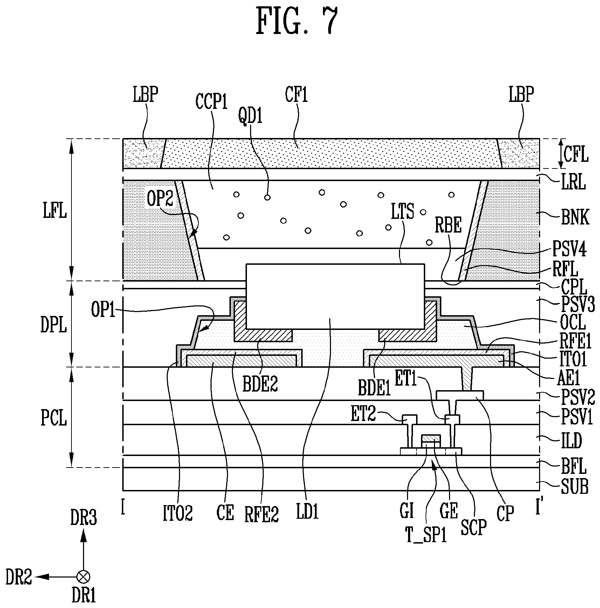

FIG. 7 is a cross-sectional view taken along line I-I' of FIG. 6.

Referring to FIGS. 6 and 7, the pixel circuit layer PCL, the display element layer DPL, and the light functional layer LFL may be sequentially disposed on the substrate SUB.

The pixel circuit layer PCL may include insulating layers, semiconductor patterns, and conductive patterns stacked on the substrate SUB. The insulating layers may include a buffer layer BFL, one or more interlayer insulating layers ILD, and one or more passivation layers PSV1 and PSV2. The semiconductor patterns and the conductive patterns may be positioned between the insulating layers. The conductive patterns may include at least one material among copper (Cu), molybdenum (Mo), tungsten (W), aluminium neodymium (AlNd), titanium (Ti), aluminium (Al), and silver (Ag).

As described with reference to FIG. 2, the sub-pixel circuit SPC (see FIG. 2) of each of the first to third sub-pixels SP1 to SP3 may include transistors and one or more capacitors. The semiconductor patterns and the conductive patterns of the pixel circuit layer PCL may function as the transistors and the capacitors of the sub-pixel circuit SPC. The conductive patterns of the pixel circuit layer PCL may further function as the lines, for example, the first to m-th gate lines GL1 to GLm, the first to n-th data lines DL1 to DLn, the power lines PL, and the pixel control lines PXCL of FIG. 1.

The buffer layer BFL may be disposed on one surface of the substrate SUB. The buffer layer BFL may prevent an impurity from diffusing into the circuit elements and the lines included in the pixel circuit layer PCL. The buffer layer BFL may include an inorganic insulating layer including an inorganic material. In embodiments, the buffer layer BFL may include at least one of metal oxides such as silicon nitride (SiNx), silicon oxide (SiOx), silicon oxynitride (SiOxNy), and aluminium oxide (AlOx). The buffer layer BFL may be provided as a single layer or multiple layers. In a case that the buffer layer BFL is provided as the multiple layers, each layer may be formed of a same material or may be formed of different materials.

In embodiments, one or more barrier layers may be disposed between the substrate SUB and the buffer layer BFL. Each of the barrier layers may include polyimide.

A transistor T_SP1 may be disposed on the buffer layer BFL. The transistor T_SP1 may be one of the transistors of the sub-pixel circuit SPC included in the first sub-pixel SP1. For example, the transistor T_SP1 may be understood as the transistor connected to the first anode electrode AE1 among the transistors of the sub-pixel circuit SPC.

The transistor T_SP1 may include a semiconductor pattern SCP, a gate electrode GE, a first terminal ET1, and a second terminal ET2. The first terminal ET1 may be one of a source electrode and a drain electrode, and the second terminal ET2 may be the other one of the source electrode and the drain electrode. For example, the first terminal ET1 may be the source electrode, and the second terminal ET2 may be the drain electrode.

The semiconductor pattern SCP may be disposed on the buffer layer BFL. The semiconductor pattern SCP may include a first contact area contacting the first terminal ET1 and a second contact area contacting the second terminal ET2. An area between the first contact area and the second contact area may be a channel area. The channel area may overlap the gate electrode GE of the transistor T_SP1. The channel area may be a semiconductor pattern that is not doped with an impurity, and may be an intrinsic semiconductor. The first contact area and the second contact area may be a semiconductor pattern doped with an impurity. As the impurity, for example, a p-type impurity may be used, but embodiments are not limited thereto.

The semiconductor pattern SCP may include at least one of various types of semiconductors, for example, an amorphous silicon semiconductor, a monocrystalline silicon semiconductor, a polycrystalline silicon semiconductor, a low-temperature polysilicon semiconductor, and an oxide semiconductor.

The interlayer insulating layers ILD sequentially stacked each other may be disposed on the semiconductor pattern SCP. The interlayer insulating layers ILD may be inorganic insulating layers including an inorganic material. For example, each of the interlayer insulating layers ILD may include at least one of metal oxides such as silicon nitride (SiNx), silicon oxide (SiOx), silicon oxynitride (SiOxNy), and aluminium oxide (AlOx). However, the interlayer insulating layers ILD are not limited thereto. For example, at least one of the interlayer insulating layers ILD may include an organic insulating layer including an organic material.

The interlayer insulating layers ILD may electrically separate conductive patterns and/or semiconductor patterns disposed between the interlayer insulating layers ILD from each other. For example, the interlayer insulating layers ILD may include a gate insulating layer GI disposed on the semiconductor pattern SCP. The gate insulating layer GI may be disposed between the semiconductor pattern SCP and the gate electrode GE so that the gate electrode GE is spaced apart from the semiconductor pattern SCP. In embodiments, the gate insulating layer GI may be provided entirely on the semiconductor pattern SCP and the buffer layer BFL to cover (or overlap) the semiconductor pattern SCP and the buffer layer BFL. As the number of layers required to form the conductive patterns and/or the semiconductor patterns increases, the number of interlayer insulating layers ILD may increase.

The gate electrode GE may be disposed on the gate insulating layer GI. The gate electrode GE may overlap the channel area of the semiconductor pattern SCP. In embodiments, the gate electrode GE may be provided as a single layer including at least one material among copper (Cu), molybdenum (Mo), tungsten (W), aluminium neodymium (AlNd), titanium (Ti), aluminium (Al), and silver (Ag). In embodiments, the gate electrode GE may be provided as multiple layers including at least one material among molybdenum (Mo), titanium (Ti), copper (Cu), aluminium (Al), and silver (Ag), which are low-resistance materials. However, embodiments are not limited thereto.

The first and second terminals ET1 and ET2 may be disposed on the interlayer insulating layers ILD. The first and second terminals ET1 and ET2 may contact the semiconductor pattern SCP through contact holes passing through the interlayer insulating layers ILD. The first and second terminals ET1 and ET2 may respectively contact the first and second contact areas of the semiconductor pattern SCP. Each of the first and second terminals ET1 and ET2 may include at least one material among copper (Cu), molybdenum (Mo), tungsten (W), aluminium neodymium (AlNd), titanium (Ti), aluminium (Al), and silver (Ag).

Although the first and second terminals ET1 and ET2 are shown as separate electrodes electrically connected to the semiconductor pattern SCP, embodiments are not limited thereto. In embodiments, the first terminal ET1 may be a first contact area adjacent to one side of the channel area of the semiconductor pattern SCP, and the second terminal ET2 may be a second contact area adjacent to another side of the channel area. In this case, the first terminal ET1 may be electrically connected to the light emitting element LD through a connection means such as a bridge electrode disposed on at least one of the interlayer insulating layers ILD.

In embodiments, the transistor T_SP1 may be configured of a low-temperature polysilicon transistor. However, embodiments are not limited thereto. For example, the transistor T_SP1 may be configured of an oxide semiconductor transistor. In embodiments, the sub-pixel circuit of the first sub-pixel SP1 may include different types of transistors. For example, the transistor T_SP1 may be configured of a low-temperature polysilicon transistor, and another transistor of the first sub-pixel SP1 may be configured of an oxide semiconductor transistor. In this case, the oxide semiconductor of the corresponding oxide semiconductor transistor may be disposed on at least one of the interlayer insulating layers ILD rather than the insulating layer on which the semiconductor pattern SCP of the transistor T_SP1 is disposed.

In embodiments, a case where the transistor T_SP1 is a transistor of a top gate structure is described as an example, but embodiments are not limited thereto. For example, the transistor T_SP1 may be a transistor of a bottom gate structure. A structure of the transistor T_SP1 may be variously changed.

At least some of the various lines of the display panel DP and/or the display device DD may be further disposed on the interlayer insulating layers ILD.

The first passivation layer PSV1 may be disposed on the interlayer insulating layers ILD and the first and second terminals ET1 and ET2. A passivation layer may be referred to as a protective layer or a via layer. The first passivation layer PSV1 may protect components disposed thereunder and may provide a flat upper surface.

A connection pattern CP may be disposed on the first passivation layer PSV1. The connection pattern CP may be connected to the first terminal ET1 of the transistor T_SP1 by passing through the first passivation layer PSV1. The connection pattern CP may include at least one material among copper (Cu), molybdenum (Mo), tungsten (W), aluminium neodymium (AlNd), titanium (Ti), aluminium (Al), and silver (Ag).

At least some of the various lines of the display panel DP and/or the display device DD may be further disposed on the first passivation layer PSV1.

The second passivation layer PSV2 may be disposed on the connection pattern CP and the first passivation layer PSV1. The second passivation layer PSV2 may protect components disposed thereunder and may provide a flat upper surface.

Each of the first and second passivation layers PSV1 and PSV2 may include an inorganic insulating layer including an inorganic material and/or an organic insulating layer including an organic material. The inorganic insulating layer may include, for example, at least one of metal oxides such as silicon nitride (SiNx), silicon oxide (SiOx), silicon oxynitride (SiOxNy), and aluminium oxide (AlOx). The organic insulating layer may include, for example, at least one of acrylic resin, epoxy resin, phenol resin, polyamide resin, polyimide resin, unsaturated polyester resin, poly-phenylene ether resin, poly-phenylene sulfide resin, and benzocyclobutene resin.

The first and second passivation layers PSV1 and PSV2 and at least one of the interlayer insulating layers ILD may include a same material, but embodiments are not limited thereto. Each of the first and second passivation layers PSV1 and PSV2 may be provided as a single layer, but may also be provided as multiple layers.

The display element layer DPL may be disposed on the second passivation layer PSV2. The display element layer DPL may include the first anode electrode AE1, the cathode electrode CE, first and second reflective electrodes RFE1 and RFE2, the first light emitting element LD1, an overcoat layer OCL, a third passivation layer PSV3, and a capping layer CPL.

The first anode electrode AE1 and the cathode electrode CE may be disposed on the pixel circuit layer PCL.

The first anode electrode AE1 may be electrically connected to the connection pattern CP through a contact hole passing through the second passivation layer PSV2. As described above, the first anode electrode AE1 may be electrically connected to the first transistor T_SP1.

The cathode electrode CE may be spaced apart from the first anode electrode AE1 in the first direction DR1. The cathode electrode CE may be electrically connected to the second power voltage node VSSN of FIG. 2. Accordingly, the second power voltage applied to the second power voltage node VSSN may be transmitted to the cathode electrode CE.

The first reflective electrode RFE1 may be disposed on the first anode electrode AE1. The first reflective electrode RFE1 may be disposed on a side surface of the first anode electrode AE1. For example, the first reflective electrode RFE1 may be disposed to surround the first anode electrode AE1.

The second reflective electrode RFE2 may be disposed on the cathode electrode CE. The second reflective electrode RFE2 may be disposed on a side surface of the cathode electrode CE. For example, the second reflective electrode RFE2 may be disposed to surround the cathode electrode CE.

The first and second reflective electrodes RFE1 and RFE2 may include conductive materials suitable for reflecting light. Accordingly, light output efficiency of the first light emitting element LD1 may be improved. The first and second reflective electrodes RFE1 and RFE2 may include a same reflective conductive material. In embodiments, the first and second reflective electrodes RFE1 and RFE2 may include at least one of aluminium (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from them. However, embodiments are not limited thereto.

The overcoat layer OCL may be disposed in a first opening OP1 where the first and second reflective electrodes RFE1 and RFE2 and the first light emitting element LD1 are disposed. The overcoat layer OCL may fix the first light emitting element LD1 so that the first light emitting element LD1 does not move. The overcoat layer OCL may protect components disposed thereunder from a foreign substance such as dust and moisture. For example, the overcoat layer OCL may include at least one of an inorganic insulating layer and an organic insulating layer. For example, the overcoat layer OCL may include epoxy, but embodiments are not limited thereto.

The first light emitting element LD1 may include first and second bonding electrodes BDE1 and BDE2 facing in a same direction (for example, a direction opposite to the third direction DR3).

The first bonding electrode BDE1 may be disposed to contact a side surface of the first light emitting element LD1 and a lower surface of the first light emitting element LD1. The first bonding electrode BDE1 may be disposed on the overcoat layer OCL and may be disposed between the first light emitting element LD1 and the overcoat layer OCL.

The first bonding electrode BDE1 may be electrically connected to a first semiconductor layer (not shown) included in the first light emitting element LD1. For example, the first semiconductor layer may include at least one p-type semiconductor layer. For example, the first semiconductor layer may include at least one semiconductor material among gallium nitride (GaN), aluminium gallium nitride (AlGaN), indium gallium nitride (InGaN), aluminium nitride (AlN), and indium nitride (InN), and may be a p-type semiconductor layer doped with a first conductive dopant (or a p-type dopant) such as magnesium (Mg), zinc (Zn), calcium (Ca), strontium (Sr), and barium (Ba). However, a material configuring the first semiconductor layer is not limited thereto, and various other materials may configure the first semiconductor layer. In an embodiment of the disclosure, the first semiconductor layer may include a gallium nitride (GaN) semiconductor material doped with a second conductive dopant (or a p-type dopant).

The second bonding electrode BDE2 may be disposed to contact the side surface of the first light emitting element LD1 and the lower surface of the first light emitting element LD1. The second bonding electrode BDE2 may be disposed on the overcoat layer OCL and may be disposed between the first light emitting element LD1 and the overcoat layer OCL. The first bonding electrode BDE1 and the second bonding electrode BDE2 may be spaced apart from each other.

The second bonding electrode BDE2 may be connected to a second semiconductor layer (not shown). For example, the second semiconductor layer may include at least one n-type semiconductor layer. For example, the second semiconductor layer may include at least one semiconductor material among gallium nitride (GaN), aluminium gallium nitride (AlGaN), indium gallium nitride (InGaN), aluminium nitride (AlN), and indium nitride (InN), and may be an n-type semiconductor layer doped with a first conductive dopant (or an n-type dopant) such as silicon (Si), germanium (Ge), or tin (Sn). However, a material configuring the second semiconductor layer is not limited thereto, and various other materials may configure the second semiconductor layer. In an embodiment of the disclosure, the second semiconductor layer may include a gallium nitride (GaN) semiconductor material doped with the first conductive dopant (or the n-type dopant).

A first transparent electrode ITO1 may directly electrically connect the first reflective electrode RFE1 and the first bonding electrode BDE1. Accordingly, the first bonding electrode BDE1 may be electrically connected to the first anode electrode AE1 through the first transparent electrode ITO1 and the first reflective electrode RFE1.

The first transparent electrode ITO1 may be disposed on the side surface of the first light emitting element LD1, and in an exposed portion of the first bonding electrode BDE1, an exposed portion of the overcoat layer OCL, and an exposed portion of the first reflective electrode RFE1.

A second transparent electrode ITO2 may directly electrically connect the second reflective electrode RFE2 and the second bonding electrode BDE2. Accordingly, the second bonding electrode BDE2 may be electrically connected to the cathode electrode CE through the second transparent electrode ITO2 and the second reflective electrode RFE2.

The second transparent electrode ITO2 may be disposed on the side surface of the first light emitting element LD1, and in an exposed portion of the second bonding electrode BDE2, an exposed portion of the overcoat layer OCL, and an exposed portion of the second reflective electrode RFE2.

In embodiments, the first and second transparent electrodes ITO1 and ITO2 may be configured to be substantially transparent or translucent to satisfy a light transmittance (e.g., a predetermined or selectable light transmittance). The first transparent electrode ITO1 and the second transparent electrode ITO2 may be disposed in a same display element layer DPL and may include a same transparent conductive material. In embodiments, the first and second transparent electrodes ITO1 and ITO2 may include at least one of various transparent conductive materials such as indium tin oxide (ITO), indium zinc oxide (IZO), zinc oxide (ZnO), indium gallium zinc oxide (IGZO), and indium tin zinc oxide (ITZO). However, a material of the first and second transparent electrodes ITO1 and ITO2 is not limited thereto.

However, during a patterning process of the first and second transparent electrodes ITO1 and ITO2, in a case that a width between the first light emitting element LD1 and the second light emitting element LD2 is narrow, the first and second transparent electrodes ITO1 and ITO2 may not follow a lower step of the first light emitting element LD1 and the second light emitting element LD2 and may be flattened, and thus a residue may occur.

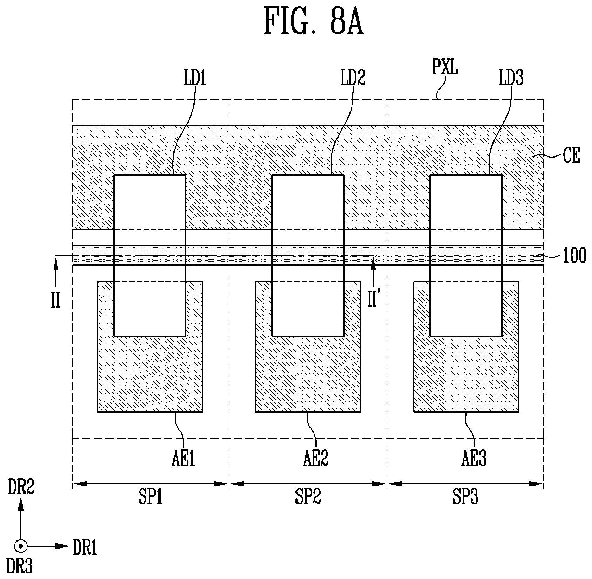

Accordingly, a short circuit may occur between at least one of the first to third anode electrodes AE1 to AE3 and the cathode electrode CE, or a short circuit may occur between the first to third anode electrodes AE1 to AE3. In order to prevent a short circuit due to the residue, an organic layer may be disposed before patterning the first and second transparent electrodes ITO1 and ITO2. A more detailed description of this is described below together with FIGS. 8A to 12.

The first and second transparent electrodes ITO1 and ITO2 may not be disposed on the first light emitting element LD1, but are not limited thereto, and the first and second transparent electrodes ITO1 and ITO2 may be disposed from an upper portion of the first light emitting element LD1 to the first and second reflective electrodes RFE1 and RFE2 according to an embodiment of the disclosure.

The third passivation layer PSV3 may be disposed on the first and second transparent electrodes ITO1 and ITO2. The third passivation layer PSV3 may protect components disposed thereunder and provide a flat upper surface. The third passivation layer PSV3 and at least one of the first and second passivation layers PSV1 and PSV2 may include a same material, but embodiments are not limited thereto.

In embodiments, the third passivation layer PSV3 may not be disposed on an upper surface LTS of the first light emitting element LD1. The first light emitting element LD1 may protrude into the light functional layer LFL. The first light emitting element LD1 may be positioned at least partially in a second opening OP2 of a bank BNK. For example, a height of the upper surface LTS of the first light emitting element LD1 from the substrate SUB may be greater than that of a lowermost end RBE of a reflective layer RFL. Accordingly, light emitted from the first light emitting element LD1 may be provided to the light functional layer LFL at a relatively high rate.

The capping layer CPL may be disposed on the third passivation layer PSV3. The capping layer CPL may protect components under the capping layer CPL, such as the first light emitting element LD1, from external water, moisture, and the like. In embodiments, the capping layer CPL may not be disposed on the upper surface of the first light emitting element LD1. In other embodiments, the capping layer CPL may entirely cover the first light emitting element LD1 and the third passivation layer PSV3. The capping layer CPL may include at least one of metal oxides such as silicon nitride (SiNx), silicon oxide (SiOx), silicon oxynitride (SiOxNy), and aluminium oxide (AlOx). However, a material of the capping layer CPL is not limited thereto.

The pixel circuit layer PCL and the display element layer DPL of the first sub-pixel SP1 are described above. Each of the second and third sub-pixels SP2 and SP3 of FIG. 6 may be configured similarly to the first sub-pixel SP1, unless otherwise described herein.

The light functional layer LFL may be disposed on the capping layer CPL. The light functional layer LFL may include a bank BNK, a reflective layer RFL, a fourth passivation layer PSV4, a first light conversion pattern CCP1, a low refractive layer LRL, and/or a color filter layer CFL.

The bank BNK may be disposed on the capping layer CPL. The bank BNK may have the second opening OP2 overlapping the first opening OP1. The bank BNK may be configured to include a light blocking material to prevent light mixing between adjacent sub-pixels. In embodiments, the bank BNK may include an organic material. For example, the bank BNK may include an organic insulating material such as acryl resin, epoxy resin, phenol resin, polyamide resin, and polyimide resin.

The reflective layer RFL may be disposed on side surfaces of the bank BNK adjacent to the second opening OP2. The reflective layer RFL may be configured to reflect incident light, thereby improving light output efficiency. The reflective layer RFL may include a material suitable for reflecting light. The reflective layer RFL may include at least one of aluminium (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from them. However, embodiments are not limited thereto.

The fourth passivation layer PSV4 may be disposed in the second opening OP2 on the capping layer CPL. The fourth passivation layer PSV4 may protect components disposed thereunder and may provide a flat upper surface. The fourth passivation layer PSV4 and at least one of the first to third passivation layers PSV1 to PSV3 may include a same material, but embodiments are not limited thereto.

The first light conversion pattern CCP1 may be disposed in the second opening OP2 on the fourth passivation layer PSV4.

The first light conversion pattern CCP1 may include color conversion particles and/or scattering particles. The color conversion particles may change a wavelength of incident light and convert the incident light into light of a different color. The color conversion particles may scatter incident light. In embodiments, the color converting particles may be quantum dots. The scattering particles may scatter incident light.

The first sub-pixel SP1 may be a red sub-pixel. In a case that the first light emitting element LD1 emits light of a blue color, the first light conversion pattern CCP1 may include first color conversion particles QD1 configured to convert the light of the blue color into light of a red color. In a case that the first light emitting element LD1 emits the light of the red color, the first light conversion pattern CCP1 may include scattering particles. As described above, particles included in the first light conversion pattern CCP1 may be variously changed according to the first light emitting element LD1.

The low refractive layer LRL may be disposed on the bank BNK, the reflective layer RFL, and the first light conversion pattern CCP1. The low refractive layer LRL may have a refractive index lower than that of the first light conversion pattern CCP1. A first color filter CF1 may have a refractive index greater than that of the low refractive layer LRL. However, embodiments are not limited thereto, and the first color filter CF1 may have a refractive index lower than or equal to that of the low refractive layer LRL. The low refractive layer LRL may be configured to refract or totally reflect corresponding light according to an incidence angle of light. For example, the low refractive layer LRL may provide light passing through the first light conversion pattern CCP1 back to the first light conversion pattern CCP1. Accordingly, light conversion efficiency of the first light conversion pattern CCP1 may be improved.

The color filter layer CFL may be disposed on the low refractive layer LRL. The color filter layer CFL may include the first color filter CF1 and light blocking patterns LBP. The first color filter CF1 may overlap the first light conversion pattern CCP1. The first color filter CF1 may selectively transmit light of a desired wavelength range. In a case that the first sub-pixel SP1 is a red sub-pixel, the first color filter CF1 may include a red color filter. The light blocking patterns LBP may include at least one of various types of light blocking materials.

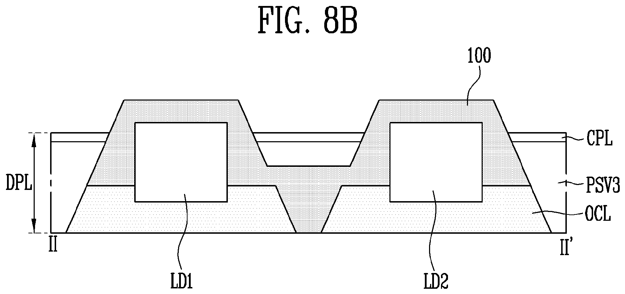

FIG. 8A is a plan view illustrating an embodiment of the disclosure including an organic layer. FIG. 8B is a cross-sectional view taken along line II-II' of FIG. 8A. Since the pixel PXL of FIG. 8A is similar to the pixel PXL of FIG. 6, an overlapping description is omitted. FIG. 8B illustrates only the display element layer DPL among the substrate SUB, the pixel circuit layer PCL, the display element layer DPL, and the light functional layer LFL shown in FIG. 7 for brevity of illustration.

Referring to FIG. 8A, an organic layer 100 may be disposed along the first direction DR1 between the cathode electrode CE and the first to third anode electrodes AE1 to AE3 in a plan view. Referring to FIG. 8B, the organic layer 100 may be disposed on the first and second light emitting elements LD1 and LD2. After patterning the organic layer 100, the first and second transparent electrodes ITO1 and ITO2 may be patterned.

As the organic layer 100 is formed before the first and second transparent electrodes ITO1 and ITO2 are formed, a short circuit or the like due to the residue remaining during a patterning process of the first and second transparent electrodes ITO1 and ITO2 may be prevented.

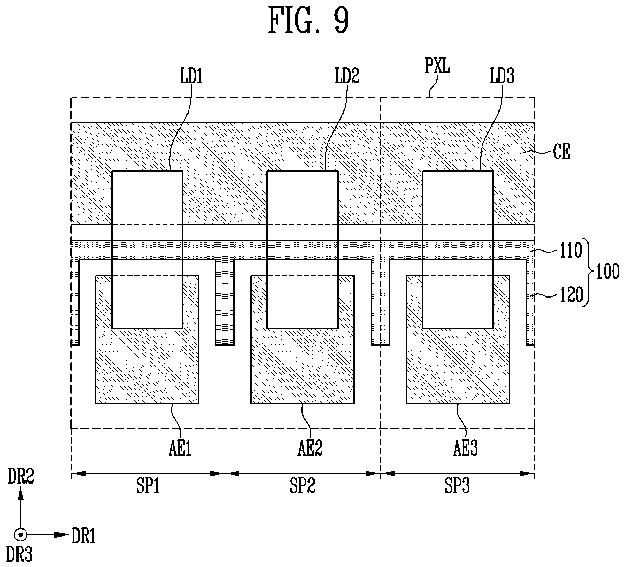

FIG. 9 is a plan view illustrating another embodiment of the disclosure including an organic layer. Since the pixel PXL of FIG. 9 is similar to the pixel PXL of FIG. 8A, an overlapping description is omitted.

Referring to FIG. 9, the organic layer 100 may include a first organic layer 110 and a second organic layer 120. The first organic layer 110 may be disposed along the first direction DR1 between the cathode electrode CE and the first to third anode electrodes AE1 to AE3. The second organic layer 120 may be disposed along the second direction DR2 between the first to third anode electrodes AE1 to AE3. Differently from that shown in FIG. 9, the second organic layer 120 may extend in the second direction DR2.

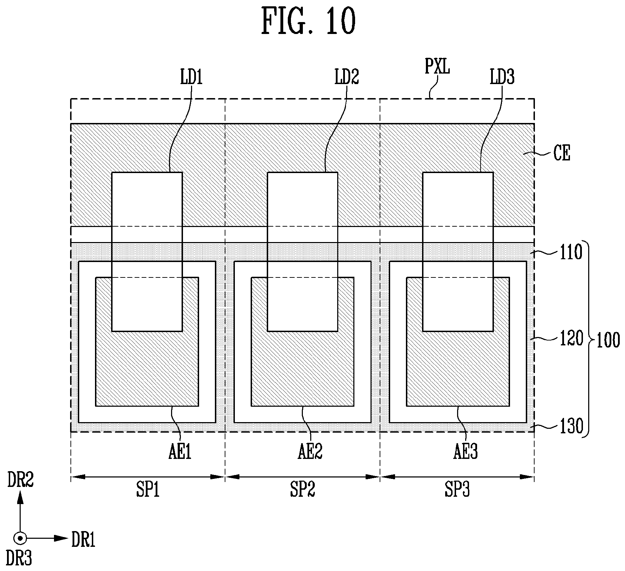

FIG. 10 is a plan view illustrating another embodiment of the disclosure including an organic layer. Since the pixel PXL of FIG. 10 is similar to the pixel PXL of FIG. 9, an overlapping descriptions is omitted.

Referring to FIG. 10, the organic layer 100 may include a first organic layer 110, a second organic layer 120, and a third organic layer 130. The first organic layer 110 may be disposed along the first direction DR1 between the cathode electrode CE and the first to third anode electrodes AE1 to AE3. The second organic layer 120 may be disposed along the second direction DR2 between the first to third anode electrodes AE1 to AE3. The first organic layer 110 may be disposed at an end of the second organic layer 120. The third organic layer 130 may be disposed along the first direction DR1 at the other end of the second organic layer 120.

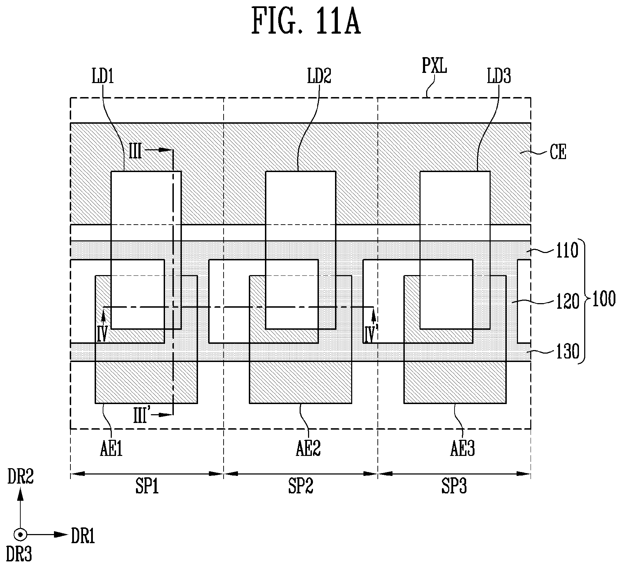

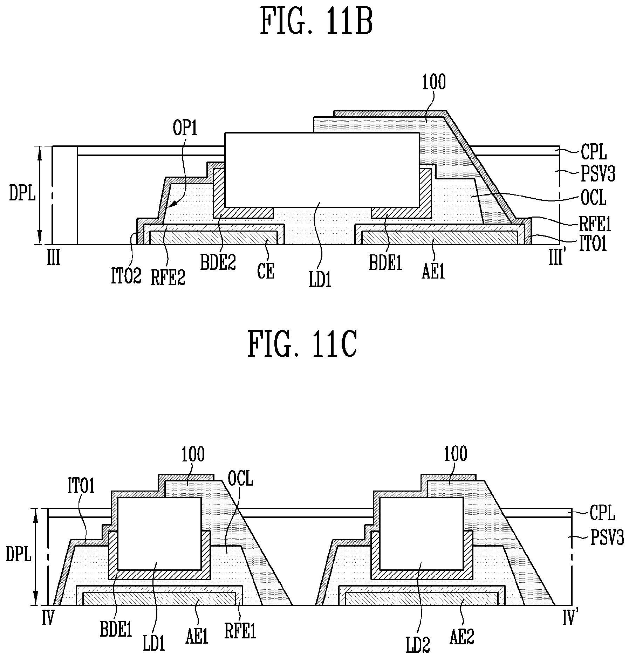

FIG. 11A is a plan view illustrating an embodiment of the disclosure including an organic layer. FIG. 11B is a cross-sectional view taken along line III-III' of FIG. 11A. FIG. 11C is a cross-sectional view taken along line IV-IV' of FIG. 11A.

Since the pixel PXL of FIG. 11A is similar to the pixel PXL of FIG. 10, an overlapping description is omitted. FIGS. 11B and 11C illustrate only the display element layer DPL among the substrate SUB, the pixel circuit layer PCL, the display element layer DPL, and the light functional layer LFL shown in FIG. 7 for brevity of illustration.

Referring to FIG. 11A, the organic layer 100 may include a first organic layer 110, a second organic layer 120, and a third organic layer 130. The first organic layer 110 may be disposed along the first direction DR1 between the cathode electrode CE and the first to third anode electrodes AE1 to AE3. The second organic layer 120 may be disposed along the second direction DR2 between the first to third anode electrodes AE1 to AE3. The second organic layer 120 may extend in the first direction DR1 and may overlap a portion of each of the first to third anode electrodes AE1 to AE3 and a portion of each of the first to third light emitting elements LD1 to LD3 for a process margin.

Referring to FIGS. 11B and 11C, the organic layer 100 may be disposed between the first light emitting element LD1 and the first transparent electrode ITO1. The organic layer 100 may overlap a portion of the first light emitting element LD1 and a portion of the first anode electrode AE1, and may overlap a portion of the second light emitting element LD2 and a portion of the second anode electrode AE2.

After patterning the organic layer 100, the first and second transparent electrodes ITO1 and ITO2 may be patterned. Accordingly, a short circuit due to the residue of the first and second transparent electrodes ITO1 and ITO2 may be prevented from occurring between the first anode electrode AE1 and the second anode electrode AE2. A short circuit due to the residue of the first and second transparent electrodes ITO1 and ITO2 may be prevented from occurring between at least one of the first to third anode electrodes AE1 to AE3 and the cathode electrode CE.

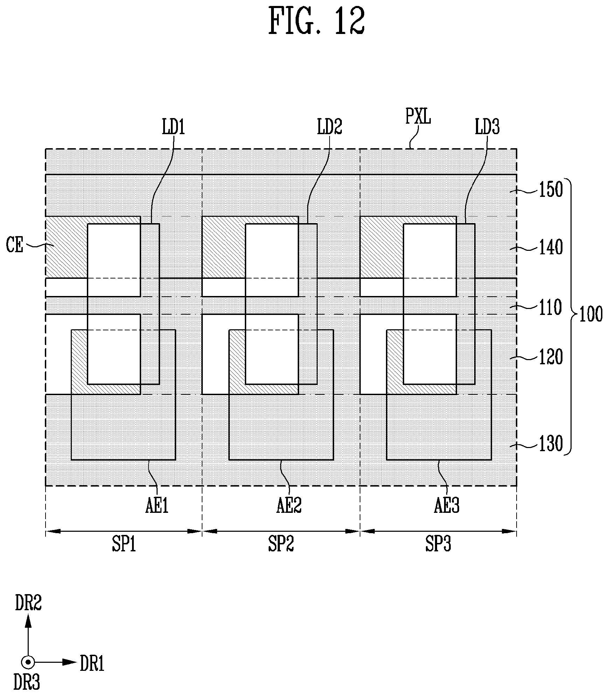

FIG. 12 is a schematic plan view illustrating another embodiment of the disclosure including an organic layer. Since the pixel PXL of FIG. 12 is similar to the pixel PXL of FIG. 11A, an overlapping description is omitted.

Referring to FIG. 12, the organic layer 100 may include a first organic layer 110, a second organic layer 120, a third organic layer 130, a fourth organic layer 140, and a fifth organic layer 150. In an embodiment, for planarization of the organic layer 100, the organic layer 100 may be disposed except for a portion for contact between the first and second transparent electrodes ITO1 and ITO2 and the first and second bonding electrodes BDE1 and BDE2, and a portion for contact between the first and second transparent electrodes ITO1 and ITO2 and the first and second reflective electrodes RFE1 and RFE2.

The fourth organic layer 140 may be disposed along the second direction DR2 between the first to third light emitting elements LD1 to LD3. The fourth organic layer 140 may overlap a portion of the cathode electrode CE. In addition, the fourth organic layer 140 may overlap a portion of each of the first to third light emitting elements LD1 to LD3 for a process margin.

The fifth organic layer 150 may be disposed in the first direction DR1. The fifth organic layer 150 may overlap a portion of the cathode electrode CE. The first organic layer 110 may be disposed at an end of the fourth organic layer 140. The fifth organic layer 150 may be disposed at the other end of the fourth organic layer 140.

The first to fifth organic layers 110 to 150 described through FIGS. 8A to 12 are only divided according to a direction in which the first to fifth organic layers 110 to 150 are disposed for convenience of description, and the first to fifth organic layers 110 to 150 may include a same organic material and may be provided as one organic layer 100. The organic layer 100 may be disposed on the light emitting elements LD1 to LD3.

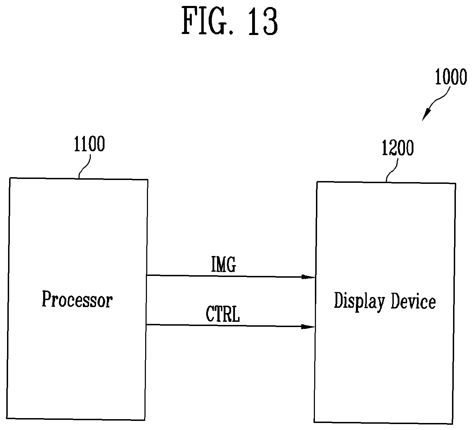

FIG. 13 is a block diagram illustrating an embodiment of a display system.

Referring to FIG. 13, the display system 1000 may include a processor 1100 and a display device 1200.

The processor 1100 may perform various tasks and calculations. In embodiments, examples of the processor 1100 may include at least one of an application processor, a graphics processor, a microprocessor, a central processing unit (CPU), and the like. The processor 1100 may be connected to other components of the display system 1000 through a bus system to control the other components.

The processor 1100 may transmit image data IMG and a control signal CTRL to the display device 1200. The display device 1200 may display an image based on the image data IMG and the control signal CTRL. The display device 1200 may be configured similarly to the display device DD described with reference to FIG. 1. In this case, the image data IMG and the control signal CTRL may be provided as the input image data IMG and the control signal CTRL of FIG. 1, respectively.

The display system 1000 may include a computing system providing an image display function, such as a smart watch, a mobile phone, a smart phone, a portable computer, a tablet personal computer (PC), a watch phone, an automotive display, smart glasses, a portable multimedia player (PMP), a navigation device, and an ultra-mobile personal computer (UMPC). The display system 1000 may include at least one of a head-mounted display (HMD) device, a virtual reality (VR) device, a mixed reality (MR) device, and an augmented reality (AR) device.

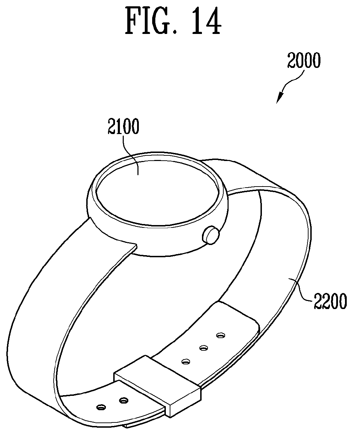

FIGS. 14 to 17 are perspective views illustrating application examples of the display system of FIG. 13.

Referring to FIG. 14, the display system 1000 of FIG. 13 may be applied to a smart watch 2000 including a display part 2100 and a strap part 2200.

The smart watch 2000 may be a wearable electronic device. For example, the smart watch 2000 may have a structure in which the strap part 2200 is mounted on a user's wrist. The display system 1000 and/or the display device 1200 may be applied to the display part 2100, and image data including time information may be provided to a user.

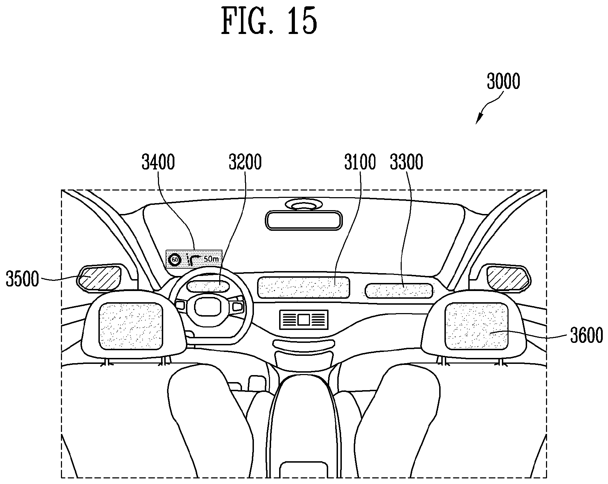

Referring to FIG. 15, the display system 1000 of FIG. 13 may be applied to an automotive display system 3000. The automotive display system 3000 may include a computing system provided inside and/or outside a vehicle to provide image data.

For example, the display system 1000 and/or the display device 1200 may be applied to at least one of an infotainment panel 3100, a cluster 3200, a co-driver display 3300, a head-up display 3400, a sideview mirror display 3500, and a rear-seat display 3600 provided in a vehicle.

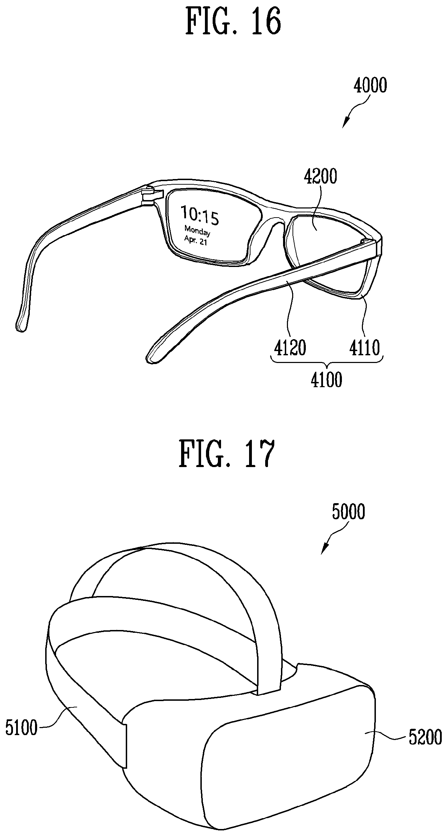

Referring to FIG. 16, the display system 1000 of FIG. 13 may be applied to smart glasses 4000. The smart glasses 4000 may be a wearable electronic device that may be worn on a user's head. For example, the smart glasses 4000 may be a wearable device for augmented reality.

The smart glasses 4000 may include a frame 4100 and a lens part 4200. The frame 4100 may include a housing 4110 that supports the lens part 4200 and a leg part 4120 for allowing the user to wear the smart glasses 4000. The leg part 4120 may be extended to the housing 4110 through a hinge and may be folded or unfolded relative to the housing 4110.

A battery, a touch pad, a microphone, a camera, and the like may be built in the frame 4100. A projector that outputs light, a processor that controls a light signal, and the like may be built in the frame 4100.

The lens part 4200 may include an optical member that transmits or reflects light. For example, the lens part 4200 may include glass, transparent synthetic resin, or the like.

In order for a user's eyes to recognize visual information, the lens part 4200 may reflect an image by the light signal transmitted from the projector of the frame 4100, by a rear surface (for example, a surface in a direction facing the user's eyes) of the lens part 4200. For example, the user may recognize visual information such as time and date displayed on the lens part 4200. The projector and/or the lens part 4200 may be a type of display device. The display device 1200 may be applied to the projector and/or the lens part 4200.

Referring to FIG. 17, the display system 1000 of FIG. 13 may be applied to a head-mounted display device 500.

The head-mounted display device 5000 may be a wearable electronic device that may be worn on a user's head. For example, the head-mounted display device 5000 may be a wearable device for virtual reality or mixed reality.

The head-mounted display device 5000 may include a head mount band 5100 and a display device receiving case 5200. The head mount band 5100 may be extended to the display device receiving case 5200. The head mount band 5100 may include a horizontal band and/or a vertical band for fixing the head-mounted display device 5000 to a user's head. The horizontal band may be configured to surround a side portion of the user's head, and the vertical band may be configured to surround an upper portion of the user's head. However, embodiments are not limited thereto. For example, the head mount band 5100 may be implemented in a form of a glasses frame, a helmet, or the like.

The display device receiving case 5200 may receive the display system 1000 and/or the display device 1200.

The above description is an example of technical features of the disclosure, and those skilled in the art to which the disclosure pertains will be able to make various modifications and variations. Thus, the embodiments of the disclosure described above may be implemented separately or in combination with each other.

Therefore, the embodiments disclosed in the disclosure are not intended to limit the technical concept of the disclosure, but to describe the technical concept of the disclosure, and the scope of the technical concept of the disclosure is not limited by these embodiments. The protection scope of the disclosure should be interpreted by the following claims, and it should be interpreted that all technical concepts within the equivalent scope are included in the scope of the disclosure.

## Claims

1. A display device comprising:
a display element layer disposed on a substrate,
wherein the display element layer comprises:
an anode electrode and a cathode electrode;
a first reflective electrode disposed on the anode electrode;
a second reflective electrode disposed on the cathode electrode;
a light emitting element including a first bonding electrode and a second bonding electrode;
a first organic layer disposed on the light emitting element and disposed between the anode electrode and the cathode electrode in a plan view;
a first transparent electrode directly electrically connecting the first reflective electrode and the first bonding electrode; and
a second transparent electrode directly electrically connecting the second reflective electrode and the second bonding electrode.

2. The display device according to claim 1, further comprising:
sub-pixels arranged in a first direction, wherein
the anode electrode includes anode electrodes corresponding to the respective sub-pixels, and
the first organic layer extends in the first direction.

3. The display device according to claim 2, further comprising:
a second organic layer disposed on the light emitting element and disposed between the anode electrodes in a plan view.

4. The display device according to claim 3, wherein
the second organic layer extends in a second direction perpendicular to the first direction, and
the first organic layer is disposed at an end of the second organic layer in a plan view.

5. The display device according to claim 4, wherein the second organic layer extends in the first direction and overlaps a portion of each of the anode electrodes.

6. The display device according to claim 5, wherein the first transparent electrode is disposed on the second organic layer.

7. The display device according to claim 4, further comprising:
a third organic layer disposed at the other end of the second organic layer in a plan view, and
the third organic layer extends in the first direction.

8. The display device according to claim 7, further comprising:
a fourth organic layer disposed on the light emitting element and extending in the second direction in a plan view; and
a fifth organic layer extending in the first direction in a plan view,
wherein the first organic layer is disposed at an end of the fourth organic layer, and the fifth organic layer is disposed at the other end of the fourth organic layer.

9. The display device according to claim 8, wherein the fourth organic layer overlaps a portion of the cathode electrode in a plan view.

10. The display device according to claim 9, wherein the second transparent electrode is disposed on the fourth organic layer.

11. The display device according to claim 8, wherein the fifth organic layer overlaps a portion of the cathode electrode in a plan view.

12. The display device according to claim 1, wherein the display element layer further includes an overcoat layer disposed in an opening where the first reflective electrode, the second reflective electrode, and the light emitting element are disposed.

13. The display device according to claim 12, wherein the overcoat layer is directly adjacent to the light emitting element.

14. The display device according to claim 1, wherein
the display element layer is disposed on an upper direction of the substrate, and
the first bonding electrode and the second bonding electrode face a lower direction of the substrate.

15. The display device according to claim 1, wherein the anode electrode and the cathode electrode are disposed in a same layer and include a same conductive material.

16. The display device according to claim 1, wherein the first transparent electrode and the second transparent electrode are patterned after patterning the first organic layer.

17. The display device according to claim 1, wherein the first reflective electrode and the second reflective electrode are disposed in a same layer and include a same reflective conductive material.

18. The display device according to claim 1, wherein the first transparent electrode and the second transparent electrode are disposed in a same layer and include a same transparent conductive material.

19. The display device according to claim 1, wherein
the first bonding electrode and the second bonding electrode are disposed on a side surface and a lower surface of the light emitting element, and
the first bonding electrode and the second bonding electrode are spaced apart from each other.

20. A display system comprising:
a processor providing image data and a control signal; and
a display device including a display panel configured to display an image corresponding to the image data in response to the control signal,
wherein the display panel comprises:
an anode electrode and a cathode electrode;
a first reflective electrode disposed on the anode electrode;
a second reflective electrode disposed on the cathode electrode;
a light emitting element including a first bonding electrode and a second bonding electrode;
a first organic layer disposed on the light emitting element and disposed between the anode electrode and the cathode electrode in a plan view;
a first transparent electrode directly electrically connecting the first reflective electrode and the first bonding electrode; and
a second transparent electrode directly electrically connecting the second reflective electrode and the second bonding electrode.
